# EUROPEAN PATENT SPECIFICATION

(11) **EP 3 308 413 B1**
(45) Date of publication and mention of the grant of the patent: **10.11.2021**
(21) Application number: 15735744.3
(22) Date of filing: 10.06.2015
(51) Int. Cl.: H01L 51/46, H01G 9/20

(54) **PHOTOVOLTAIC DEVICE AND COMPONENTS**
PHOTOVOLTAIKZELLE UND KOMPONENTEN
DISPOSITIF PHOTOVOLTAÏQUE ET COMPOSANTS

(43) Date of publication of application: 18.04.2018
(73) Proprietor: Solarpaint Ltd., 3081500 D.N. Hof Carmel (IL)
(72) Inventor: MAIMON, Eran, 1896500 Kibbutz Ein Harod Meuhad (IL)
(74) Representative: Harrison IP Limited
(86) International application number: PCT/IL2015/050588
(87) International publication number: WO 2016/199118

(56) References cited:
- EP-A1- 2 804 232
- WO-A2-2004/086462
- US-A1- 2008 047 601
- MINWOO NAM ET AL: "Efficiency enhancement in organic solar cells by configuring hybrid interfaces with narrow bandgap PbSSe nanocrystals", ORGANIC ELECTRONICS, ELSEVIER, AMSTERDAM, NL, vol. 13, no. 9, 18 April 2012 (2012-04-18) , pages 1546-1552, XP028505135, ISSN: 1566-1199, DOI: 10.1016/J.ORGEL.2012.04.028 [retrieved on 2012-05-17]
- BANDARA J ET AL: "Solid-state dye-sensitized solar cell with p-type NiO as a hole collector", SOLAR ENERGY MATERIALS AND SOLAR CELLS, ELSEVIER SCIENCE PUBLISHERS, AMSTERDAM, NL, vol. 85, no. 3, 31 January 2005 (2005-01-31), pages 385-390, XP027815035, ISSN: 0927-0248 [retrieved on 2005-01-31]
- HUI-SEON KIM ET AL: "High Efficiency Solid-State Sensitized Solar Cell-Based on Submicrometer Rutile TiO 2 Nanorod and CH 3 NH 3 PbI 3 Perovskite Sensitizer", NANO LETTERS, vol. 13, no. 6, 14 May 2013 (2013-05-14), pages 2412-2417, XP55226428, US ISSN: 1530-6984, DOI: 10.1021/nl400286w
- SUZUKI K ET AL: "APPLICATION OF CARBON NANOTUBES TO COUNTER ELECTRODES OF DYE-SENSITIZED SOLAR CELLS", CHEMISTRY LETTERS, CHEMICAL SOCIETY OF JAPAN, JAPAN, vol. 32, no. 1, 1 January 2003 (2003-01-01), page 28/29, XP008025168, ISSN: 0366-7022, DOI: 10.1246/CL.2003.28
- WOUTER WOESTENBORGHS ET AL: "Analysis of a transparent organic photoconductive sensor", ORGANIC ELECTRONICS, vol. 13, no. 11, 1 November 2012 (2012-11-01), pages 2250-2256, XP55130148, ISSN: 1566-1199, DOI: 10.1016/j.orgel.2012.06.049
- Ara Cho ET AL: "Carbon layer reduction via a hybrid ink of binary nanoparticles in non-vacuum-processed CuInSe2 thin films", Solar Energy Materials and Solar Cells, vol. 110, 1 March 2013 (2013-03-01), pages 126-132, XP055771118, NL ISSN: 0927-0248, DOI: 10.1016/j.solmat.2012.12.013
- Matthew J. Carnie ET AL: "A one-step low temperature processing route for organolead halide perovskite solar cells", Chemical Communications, vol. 49, no. 72, 1 January 2013 (2013-01-01), page 7893, XP055297971, ISSN: 1359-7345, DOI: 10.1039/c3cc44177f
- Pablo P. Boix ET AL: "Perovskite Solar Cells: Beyond Methylammonium Lead Iodide", Journal of Physical Chemistry Letters, vol. 6, no. 5, 13 February 2015 (2015-02-13), pages 898-907, XP055499653, US ISSN: 1948-7185, DOI: 10.1021/jz502547f

## Description

### TECHNOLOGICAL FIELD

The present invention relates to techniques for producing photovoltaic devices, material composition and a charge collection system for the same.

### BACKGROUND

Demand for renewable energy and in particular solar energy is constantly rising, aiming to provide alternatives for fossil fuel. The use of solar energy is becoming one of the most promising alternatives for a regenerating energy source, providing an abundance of available energy that can be converted to electrical energy.

The typical commercially available solar harvesting systems utilize a preconfigured solar panel prepared for harvesting optical energy and converting the harvested energy to electrical power. The panels are provided with a suitable electrical connection to collect generated charge carriers from different regions of the panel and to direct the collected energy through dedicated peripheral circuitry to the grid, a storage device (e.g. battery) and/or a load.

Patent application publication number US 2008/0047601 A1 describes a Schottky contact photovoltaic energy conversion cell. The cell comprises a flexible substrate and a first array of a plurality of closely-spaced microscale pillars connected to a first electrical cell contact. The pillars and the contact are formed of (or having a top) layer of a first Schottky metal material with a work function selected for efficiently collecting photogenerated electrons. The cell further comprises a second array of a plurality of closely-spaced microscale pillars connected to a second electrical cell contact. The pillars and the contact are formed of (or having a top) layer of a second Schottky metal material with a work function selected for efficiently collecting photogenerated holes. The cell further comprises a semiconductor absorber thin-film layer covering the first and second contacts and filling spaces among all the pillars, for creating photogenerated electrons and holes.

The publication "Carbon layer reduction via a hybrid ink of binary nanoparticles in non-vacuum-processed CuInSe2 thin films", by Ara Cho et al. (2013), describes that in order to reduce the thick carbon layer between the Mo back contact and the CuInSe₂ (CIS) absorber in non-vacuum-processed CIS solar cells, a hybrid ink was used to form a CuInSe₂ (CIS) thin film. The hybrid ink consists of binary nanoparticles (CuS and In-Se) and a precursor solution. Binary nanoparticles were synthesized by a low-temperature colloidal process and acted as stress-relief and crack-deflection centers in the hybrid ink. A precursor solution was prepared with a chelating agent that acted to effectively bind the nanoparticles without other binders. The use of nanoparticles made it possible to reduce the carbon layer due to the easy removal of organics in the precursor solution through the pores between the nanoparticles.

The publication "A one-step low temperature processing route for organolead halide perovskite solar cells" by Matthew J. Carnie et al. (2013) describes organolead trihalide perovskite solar cells based upon the co-deposition of a combined Al₂O₃― perovskite layer at *T*< 110 °C. It reports an average PCE = 7.2% on a non-sintered Al₂O₃ scaffold in devices that have been manufactured from a perovskite precursor containing 5 wt% Al₂O₃ nanoparticles.

The publication "Perovskite Solar Cells: Beyond Methylammonium Lead Iodide" by Pablo P. Boix et al. (2015) reviews the perovskite solar cells, providing a special focus on compounds beyond Methylammonium Lead Iodide such as Sn-based halide perovskites.

### GENERAL DESCRIPTION

As indicated above, various types of photovoltaic devices and systems are commercially available and have been developed. Such solar harvesting devices/systems typically require specific production processes within dedicated factories.

There is a need in the art for an efficient, simple and robust technique allowing simplified production processes of photovoltaic devices, also allowing on-site production of photovoltaic devices.

A photovoltaic device is provided as recited in claim 1.

A method of assembling a photovoltaic device is also provided as recited in claim 10.

The present invention provides a novel technique and media allowing for converting surfaces of different types to photovoltaic systems to thereby provide harvesting of solar energy.

Generally, the present invention utilizes a dedicated electrode arrangement and a suitable material, for applying to (e.g. depositing on) the electrode arrangement. This material is in the form of a liquid suspension or solution, or at times in the form of powder, and can be applied on a surface (e.g. by painting the surface). The material is prepared such that when applied on a surface and subsequent to certain drying and/or curing processes, the remaining residue operates as an optically active film, generating charge carriers in response to electromagnetic radiation (e.g. optical radiation) incident thereon. For example, according to some embodiments of the invention the material is in the form of a suspension within a liquid carrier thus providing a paint-like medium. Applying such liquid suspension on a surface and allowing the liquid carrier to evaporate results in a polycrystalline residue on the surface acting as the optically active film. The electrode arrangement, which is below or above the polycrystalline film, is configured as both the charge carriers' transport media and electrical contact structure. More specifically, the electrode arrangement comprises at least two sets of electrode elements, each configured to allow collection and transfer of positive or negative charge carriers generated by the optically active film.

To this end, the present invention utilizes a material mixture configured to be acting as paint (or paint-like) when applied on a surface. The applied mixture is subsequently dried or cured, leaving on the surface an optically active polycrystalline film of the material. The material composition of the mixture is selected such that the optically active film formed on the surface is capable of generating charge carriers in response to absorbed incident electromagnetic radiation of one or more wavelength ranges.

More specifically, the "paint" mixture generally comprises colloidal structures comprising nucleation assisting particles and optically active semiconducting particles (of various sizes and geometries, from the nanometric regime and up to sizes of hundreds of micrometers). The structures are preferably suspended or dissolved within the liquid carrier to provide a suspension mixture or a solution (termed here "liquid mixture"). In some other examples not forming part of the claimed invention, the "paint" mixture may be provided as a powder. Additionally, in the embodiments utilizing the liquid mixture (suspension or solution), the mixture generally further comprises at least one, and preferably two or more, types of soluble material dissolved in the liquid carrier. Preferably, the at least one type of soluble material and the optically active particles are selected such that when the liquid carrier is allowed to evaporate, under predetermined conditions, the at least one soluble material interacts with the colloidal structures to form a substantially continuous film of the optically active polycrystalline material.

It should be noted, that in some embodiments of the invention, and particularly when the paint-like material (liquid mixture) is in the form of a solution of soluble material capable of forming the optically active polycrystalline film, the polycrystalline film itself may be formed utilizing surface interaction effects causing nucleation of the optically active semiconductor structures. In this configuration, the surface to be painted may be pre-treated, and/or the electrode arrangement may be configured, to provide an appropriate surface pattern (e.g. roughness of the surface) to thereby promote nucleation of the optically active semiconductor structure.

In this connection, it should be noted that the terms *suspended* or *suspension* as used herein refer generally to particles/grains within a liquid carrier; such that at least a portion of the particles/grains are insoluble in the liquid carrier or require a further material (reacting agent; catalyst) to change the solubility of said of the particles/grains in the liquid carrier. The particles/grains may vary in size and/or geometry and may be in the nanometric or micrometric scale. In some embodiments, the size of the particles/grains is between one and a few nanometers or is between one nanometer and a few microns. The *soluble material* refers to a material that is substantially soluble in the liquid carrier containing it.

The term *nucleation assisting particles* refers to a material, typically in the form of material particles (discrete particles media) which are capable of associating thereto, by physical or otherwise chemical forces, one or more of the optically-active semiconducting structures. In some cases, the nucleation assisting particles are selected to induce aggregation (or to associate with or to bring about nucleation) of the optically active semiconducting structures from the soluble material present in the vicinity of the particles, such that colloidal structures are formed. The *colloidal structures* are generally the material composition resulting from the interaction of the nucleation assisting particles and the optically-active semiconducting structures. The two or more components making up the colloidal structures are held together by physical or chemical interactions and may be in the form of homogenous or heterogeneous structures (in some embodiments, they may be associated or may cause nucleation of one or more types of optically active materials). The colloidal structures may or may not be of uniform chemical composition.

The formed colloidal structures may be of varying sizes and shapes, and their formation may be spontaneous in the presence of the nucleation assisting particles. Without wishing to be bound by theory, the ability of the nucleation assisting particles to associate, form aggregates or cause nucleation of surrounding materials there-around, depends, *inter alia,* on the concentration of the nucleation assisting particles, their material composition, size, morphology, as well as physical or chemical affinity to the surrounding materials, for example parameters such as crystal matching with respect to the desired nucleated crystal.

In some embodiments, the nucleation assisting particles are selected amongst nanometric particles capable of acting as nucleation centers for at least one material present in the liquid mixture (a suspension or solution) according to or used in accordance with the invention. The nucleation assisting particles may comprise particles selected from the following materials: oxides, nitrides, halides, sulfides, phosphides; plasmonic nanoparticles, nano-cellulose, and fiberglass. In some configurations, the oxides may comprise fumed silica (SiO₂). In some embodiments, the oxides may be selected amongst metal oxides. For example, such metal oxides may be selected from SnO₂, Al₂O₃ and TiO₂. A liquid carrier is typically a liquid medium containing at least one of the constituents of the suspension or solution. The liquid carrier may generally be selected to have an appropriate boiling point or vapor pressure, which would permit its evaporation. For example, this may be transformation of molecular particles of the liquid carrier from being part of the liquid phase to a gas phase. The liquid carrier composition also maintains the correct saturation balance between the materials in the dissolved and colloidal states.

As noted herein, the at least one soluble material is selected such that when the liquid medium is applied on a surface and the liquid carrier is allowed to evaporate, the soluble material interacts with the colloidal structures to form a continuous polycrystalline film of said optically active semiconducting structures. The interaction between the soluble material and the colloidal structures may be any or both of physical and chemical interactions; the interaction may be selected from van der Walls interaction, ionic interaction, complex forming, hydrogen bonding, and others. Preferably, the interaction is irreversible in the solid phase, thus forming a stable and continuous polycrystalline film comprising a plurality of crystalline structures.

The *polycrystalline film* thus produced is a material comprising a plurality of particles, i.e., crystal structures, which are associated directly together by inter-particle interaction. The crystal structures of the individual grains of the material may be randomly oriented in space within the polycrystalline material or arranged in a predefined order (pattern). Different crystallite grains of the polycrystalline film may be spaced apart between them by regions of amorphous material and/or interfacing other crystallite grain.

As described above, the electrode arrangement is generally provided according to embodiments of the present invention, for collection of charges carriers) generated by the optically active polycrystalline film on the surface in response to incident electromagnetic radiation. The electrode arrangement comprises at least first and second patterned electrodes (preferably flat or planar electrode elements), e.g. formed with perforations, and/or interdigital configuration, such that effective electrical contact is provided between each of the electrode elements and the polycrystalline film, while the electrode elements are electrically insulated between them. The configuration is such that the first and second electrode elements provide selective collection of charge carriers of different polarities/signs, respectively. This provides charge separation by collection of charge carriers of different polarities into two separate conduction elements conducting the collected charges to a peripheral circuitry (e.g. to be collected in a battery or to a load).

For example, one of the electrode elements collects positive charge carriers and blocks collection of negative charge carriers, and the other electrode element collects negative charge carriers and blocks collection of positive charge carriers. Alternatively, in some embodiments of the invention, one of the first and second electrode elements is configured to collect charge carriers of a specific sign (positive or negative charge carriers) and prevent collection of charge carriers of the other sign, while the other electrode element may generally allow collection of charge carriers of both signs.

Generally, the first and second electrode elements of the electrode arrangement are configured to provide the desired selective collection of charge carriers in accordance with the energy band structure of the electrode materials and of the corresponding optically active material that is to be used with the electrode elements. More specifically, the electrode elements comprise a material composition (e.g. made of or coated thereby) having a desired band structure such that the energy level of the effective valence band or work function of the positive electrode elements is of substantially similar and preferably a bit higher energy level as the effective valence level of the optically active material, thereby allowing collection of positive charge carriers (e.g. holes). This is while the conduction band (for non-metallic electrode coating) of said electrode element is located substantially higher with respect to the conduction band of the optically active material, thus preventing collection of negative charge carriers (e.g. electrons). A similar but opposite relation may be provided between the negative electrode element and the optically active material, i.e. the effective conduction band of the electrode is of similar and preferably a bit lower energy level than the effective conduction band of the optically active material, and the effective valence band energy level is substantially lower in energy than the effective valence band of the optically active material, thus providing collection of negative charge carriers (e.g. electrons) while preventing collection of positive charge carriers (e.g. holes). As indicated above, in some configurations, only one of the electrodes is configured to provide specific charge collection while the second may be configured to collect charges of any sign.

Additionally, the electrode arrangement, including the patterned electrode elements thereof, is preferably configured to be extendible to be desirably deployed on a selected surface. The electrode arrangement may be configured as a flat sheet-like arrangement being folded or rolled and ready to be unfolded or unrolled and attached to the selected surface.

Thus, the optically active medium (paint mixture) and the electrode arrangement as described above may be used in combination for producing a photovoltaic device on the spot or in an assembly line. It should be understood that the so designed patterned electrode arrangement, made of or coated by *n-* and/or *p*-type electrically conductive materials, when directly interacting with the optically active film material, provides the device operation as photovoltaic cell, while the collected charges are directly transportable to a destination. To this end, the production of a photovoltaic device according to the technique of the invention comprises deployment of the electrode arrangement on a selected surface, applying layer(s) of the paint-like colloidal mixture on the electrode arrangement, and allowing the liquid carrier of the mixture to evaporate and the paint-like colloidal mixture to dry and/or cure, to thereby create an optically active polycrystalline film on the surface. It should be noted that, generally, the paint-like colloidal mixture may be applied directly on the surface, and while being in the liquid or semi-liquid phase be covered by the patterned electrode arrangement. In yet another example, the structure formed by the optically active polycrystalline film with the electrode arrangement may be prepared and then assembled (e.g. rolled out) on the desired surface. The electrode elements of the electrode arrangement may then be connected to a peripheral circuitry and to an electricity storage unit (battery), the grid or a load, and upon exposure to electromagnetic radiation the photovoltaic device may produce and collect electric energy.

The above technique provides a photovoltaic device comprising an optically active polycrystalline film and an electrode arrangement comprising at least first and second electrode elements configured for collection of charge carriers generated by said optically active polycrystalline film in response to incident electromagnetic radiation. The optically active polycrystalline film is characterized as comprising semiconducting material that is deposited from a liquid mixture (suspension and/or solution of liquid carrier), or by suitable powder-like mixture, at temperature below 500°C. This simplifies the production of the photovoltaic device and allows it to be assembled in generally any location, be it a dedicated factory, assembly line and/or on-site, while eliminating or at least significantly reducing the amount of training required for producing such a photovoltaic device.

Thus, according to one broad aspect of the invention, there is provided a medium comprising a liquid carrier comprising: suspended colloidal structures comprising nucleation assisting particles and optically active semiconducting structures; and at least one soluble material selected to interact with said colloidal structures such that when said medium is applied on a surface and the liquid carrier is allowed to evaporate, said interaction of the at least one soluble material with said colloidal structures creates a continuous polycrystalline film of said optically active semiconducting structures.

The colloidal structures may be of size between 1 nm and 5000 nm along at least one dimension, or of size between 150 nm and 1000 nm along at least one dimension.

Typically, the size of the crystallites of said polycrystalline film after interaction with said at least one soluble material may be increased to at least 500 nm.

According to some examples not forming part of the claimed invention, the optically active semiconducting structures may include copper phenanthroline.

According to some examples not forming part of the claimed invention, the optically active semiconducting structures and said at least one soluble material may each be independently selected from material composition comprising group IV elements of the periodic table. More specifically, the optically active semiconducting structures and the at least one soluble material may be of the same material compositions or different material compositions. In some configurations, the optically active semiconducting structures may be a product of the at least one soluble material when not in aqueous state (dissolved in a solution). The material composition comprising group IV elements of the Periodic Table may be selected from Pb or Sn compounds. Namely, for example, compounds comprising one or more metal atoms selected amongst group IV of the periodic table of the elements, such as Pb and Sn.

In some examples not forming part of the claimed invention, the Pb or Sn compound may be a molecular salt compound. For example, this may be a salt comprising one or more molecular ions having ionic interaction with one or more ions. Generally, at least one atom in the molecule bears a positive or negative charge and at least one counter ion which may be selected amongst molecular ions of the opposite charge and atoms of the opposite charge. The molecular salt may be in a form of a halide salt.

According to yet some examples not forming part of the claimed invention, said optically active semiconducting structures and said at least one soluble material may be independently selected from a compound having the general formula TₙLₘGₖ, wherein T is a cation (defined as positively charged atom or molecular ion), L is a metal atom (which may carry electric charge or not), G is an halide atom (for example I, Br, Cl or F atom), and wherein each of n, m and k, independently of each other, is between 0.2 and 6. More specifically, the values of n, m or k may be any integer or any fraction which is stoichiometrically appropriate between 0.2 and 6. In some embodiments, each of n, m and k, independently of the other may be selected from 0.5, 0.6, 0.7, 0.8, 0.9, 1, 1.1, 1.2, 1.3, 1.4, 1.5, 1.6, 1.7, 1.8, 1.9 and 2.

In some examples not forming part of the claimed invention, T may be a positively charged atom. In some examples not forming part of the claimed invention T, being a positively charged atom, may be selected from groups I and II elements of the periodic table. For example, the positively charged atom may be selected from Li, Na, K, Rb and Cs. Additionally, or alternatively, the positively charged atom may be selected from Be, Mg, Ca, Sr and Ba. In some examples not forming part of the claimed invention, the cation, T, may be selected form a set of small organic cations. For example, the cation, T, may be selected form: methyl ammonium, ethyl ammonium, methyl-formamidinium or formamidinium.

According to the claimed invention, the compounds used as the semiconducting structure are selected from Rb₂SnₘI₆, Cs₂SnₘI₆, Cs₂SnₘCl₆, Rb₂SnₘCl₆, CsSnₘI₃, Cs₂SnₘBr₆, Rb₂SnₘBr₆, and any combination of them wherein each value of m, independently of the other, is between 0.2 and 6.

In some examples not forming part of the claimed invention, the compounds of the general formula TₙLₘGₖ may be selected from Rb₂SnₘI₆, Cs₂SnₘI₆, Cs₂SnₘCl₆, Rb₂SnₘCl₆, CsSnₘI₃, Cs₂SnₘBr₆, Rb₂SnₘBr₆, CsSnₘI₅, CsSnₘI₃, Rb₂SnₘI₆, CsPbₘI₃, Cs₂PbₘI₆, (CH₃NH₃)PbₘI₃, HC(NH₂)₂PbI₃, (CH₃NH₃)SnₘI₃, HC(NH₂)₂SnI₃ and any combination of them, wherein each value of m, independently of the other, is between 0.5 and 2.

In some examples not forming part of the claimed invention, the compounds of the general formula TₙLₘGₖ may be selected from: Rb₂SnI₆, Cs₂SnI₆, Cs₂SnCl₆, Rb₂Sn₂Cl₆, Cs₂Sn₂Br₆, Rb₂Sn₂Br₆, CsSn₂I₅, RbSn₂I₅, RbSn₂Cl₅, RbSn₂Br₅, CsSn₂Br₅, CsSn₂Cl₅, CsPbI₃, Cs₂PbI₆, (CH₃NH₃)PbI₃, HC(NH₂)₂PbI₃, (CH₃NH₃)SnI₃, and HC(NH₂)₂SnI₃, (CH₃NH₃)₂PbI₆, HC(NH₂)₂PbI₆, (CH₃NH₃)₂SnI₆ and HC(NH₂)₂SnI₆. According to some examples not forming part of the claimed invention, the at least one soluble material may comprise soluble products of one or more precursors within said liquid carrier; said one or more precursors may be selected from Csl, SnI₄ ,SnI₂, SnBr₂, SnBr₄, SnCl₂, SnCl₄, SnF₂, SnF₄, CsBr, CsCl, Rbl, RbCl and RbBr.

According to some embodiments of the present invention, the nucleation assisting particles may comprise particles selected from the following materials: oxides, nitrides, halides, sulfides, Phosphides; plasmonic nanoparticles, nano-cellulose, and fiberglass. In some configurations, the oxides may comprise fumed silica (SiO₂). In some embodiments, the oxides may be selected amongst metal oxides. For example, such metal oxides may be selected from SnO₂, Al₂O₃ and TiO_{2.}

Generally, in some embodiments, the nucleation assisting particles may comprise particles having diameters between one nanometer to one millimeter. In some preferred embodiments, the nucleation assisting particles may comprise particles having diameters between 10 nm to 50 µm.

The liquid carrier may comprise, in some embodiments, at least one of the following: water, alcohols, dimethylformamide (DMF), dimethylsulfoxide (DMSO) and N-methyl-2-pyrrolidone (NMP). In some configurations the liquid carrier may be a mixture of one or more liquids, for example the liquid carrier may comprise alcohol and water.

According to some embodiments of the invention, the optically active medium may further comprise at least one binding material. Such at least one binding material may be selected from polyalkylacrylates, poly(meth)acrylates, and polysiloxanes.

Additionally, or alternatively, the optically active medium may further comprise at least one doping material. Such at least one doping material may be selected to increase the density of charge carriers in said continuous polycrystalline film. Additionally or alternatively, said at least one doping material may be selected to induce dipoles in the crystalline form to thereby reduce recombination rate of charge carriers. The at least one doping material may comprise at least one p-type dopant. In some configurations, the at least one doping material may be selected from halide-based soluble salts; for example, the doping material may be selected from SnI₂, SnF₂, CsF and MeNH₃I salts.

In some embodiments, the optically active medium may further comprise at least one of the following: lithium bis-trifluoromethanesulfonimide (LiTFSI) and tBu-Pyridine.

According to another broad aspect of the invention, there is provided a kit for use in assembling a photovoltaic device on a surface, the kit comprising: the optically active medium described above and an electrode arrangement. The electrode arrangement is configured for extending along the surface and comprising at least first and second patterned electrodes configured respectively for selective collection of positive and negative charge carriers created in said optically active medium, when applied to the surface, in response to electromagnetic radiation incident thereon, thereby converting the selected surface to the photovoltaic device.

According to yet further aspect of the invention, it provides a method of assembling a photovoltaic device on a surface. The method comprises providing, on said surface, an electrode arrangement in direct interaction with a liquid medium, and allowing said medium to be dried or cured thereby creating an optically active film interacting with the electrode arrangement, wherein: said liquid medium comprises a liquid carrier comprising: suspended colloidal structures comprising nucleation assisting particles and optically active semiconducting structures; and at least one soluble material selected to interact with said colloidal structures on said surface to create a continuous optically active polycrystalline film; and the electrode arrangement comprises at least first and second patterned electrodes configured, in accordance with material properties of said optically active semiconductor film, to allow selective collection of charge carriers of opposite polarities generated in said optically active film by the first and second electrodes respectively; wherein said optically active layer is located between a radiation source and said electrode arrangement; the optically active semiconductor layer comprises optically active semiconducting structures that are selected from: Rb₂SnₘI₆, Cs₂SnₘI₆, Cs₂SnₘCl₆, Rb₂SnₘCl₆, CsSnₘI₃, Cs₂SnₘBr₆, Rb₂SnₘBr₆, and any combination of them; wherein each value of m, independently of the other, is between 0.2 and 6. Preferably, additional protective layer, which may be optically transparent for at least predetermined wavelength range may be provided on top of the polycrystalline film. Such protective layer may be clear-coat or semi clear coat and is configured to provide additional protection to the polycrystalline film.

In the photovoltaic device according to the claimed invention the electrode arrangement is configured for collection of charge carriers from a medium interacting with said electrodes. The electrode arrangement comprising at least one pair of first and second electrode elements configured as spaced-apart patterned electrode elements installable on and extendable along a surface, said first and second electrode elements being configured to allow transport of negative and positive charge carriers respectively, such that when said electrode arrangement interacts with an optically active medium applied to said surface the first and second electrode elements collect respective charge carriers released in said optically active medium in response to electromagnetic radiation.

The first and second electrode elements may comprise materials having an energy band structure configured in accordance with the energy band structure of at least one predetermined optically active material to provide selective collection of negatively and positively charged carriers. The first electrode element may comprise TiO₂, SnO₂, ZnO. The second electrode element may comprise at least one of NiO, Au, GO(Graphene oxide), carbon nanotubes, graphene, graphite, fullerenes, CdS, ZnGaNO, Ni, Pt, NiO, MoO₂, CuO, Cu₂O, Cu₃O₄, CuS, Cu₂S, Cul, Fe₂S, Cu₃P, copper phenanthroline, iron oxides, iron sulfides, WO₂, CuSCN, and Cu₃N.

According to some embodiments of the invention, the first and second electrode elements may be arranged in a spaced apart relationship within a single layer. The first and second patterned electrode elements may be arranged in an interdigital configuration with their finger members being intertwined between them within said single layer. Finger members of said first and second electrode elements may have a width between 100 nanometers and 1 millimeter, or preferably between 500 nanometer and 100 micrometers. Additionally or alternatively, a distance between adjacent finger members of different electrode elements may be between 100 nanometers and 75 micrometers. In some configurations, the distance between adjacent finger members of different electrode elements may be between 5 micrometer and 1 milimeter.

In the photovoltaic device according to the claimed invention, the first and second electrode elements may be located in first and second layers, respectively. The first and second electrode elements may be configured with a mesh-like or net configuration to thereby allow passage of optical radiation therethrough. The mesh-like or net configuration may be characterized by having spaced-apart electrode regions of width between 1 micrometer and 100 micrometers separated by empty regions of width between 1 micrometer and 100 micrometers.

In some embodiments of the invention, the electrode arrangement may further comprise a sheet of insulating material configured for carrying said first and second electrode elements. The sheet of insulating material may be configured from a degradable material configured to dissolve due to exposure to air after a predetermined time.

In some embodiments of the invention, the electrode arrangement may be configured as a foldable assembly, configured for deployment on a selected surface for use in conversion of said selected surface to a photovoltaic panel.

The electrode arrangement may comprise at least two regions, each region comprising said at least first and second electrode elements, said electrode elements of said at least two regions may be connected between them in series to provide increased accumulated voltage in response to collection of charge carriers. Alternatively, such at least two regions may be connected between them in parallel to thereby increase accumulated current in response to collection of charge carriers. Generally such configuration may enhance robustness of the system, e.g. by providing bypass sections and blocking diodes at desired locations. This allows further maintenance of the electrode arrangement such as blocking off malfunctioning or weak (e.g. shaded) sections of the resulting photovoltaic surface.

According to yet another broad aspect of the present invention, there is provided a photovoltaic device comprising a layered structure on a substrate comprising: an electrode arrangement comprising first and second patterned electrode elements and an optically active semiconductor layer in direct interaction with said electrode arrangement, said optically active semiconductor layer being configured to generate charge carriers in response to impinging electromagnetic radiation; the electrode arrangement being configured, in accordance with material properties of said optically active semiconductor layer, to allow selective collection of charge carriers of opposite polarities generated in said optically active layer by the first and second electrodes respectively; wherein said optically active layer is located between a radiation source and said electrode arrangement; the optically active semiconductor layer comprises optically active semiconducting structures that are selected from: Rb₂SnₘI₆, Cs₂SnₘI₆, Cs₂SnₘCl₆, Rb₂SnₘCl₆, CsSnₘI₃, Cs₂SnₘBr₆, Rb₂SnₘBr₆, and any combination of them; wherein each value of m, independently of the other, is between 0.2 and 6.

Some examples not forming part of the claimed invention provide a photovoltaic device comprising: an optically active polycrystalline film; and an electrode arrangement comprising at least first and second electrode elements configured for collection and transport of charge carriers of first and second polarities generated by said optically active polycrystalline film in response to incident electromagnetic radiation. The optically active polycrystalline film comprises at least one semiconducting material deposited from suspension of liquid carrier on a surface carrying said electrode arrangement at temperature below 500°C and transformable, upon evaporation of said liquid carrier into said optically active polycrystalline film.

The optically active layer may be directly exposed to input electromagnetic radiation. In some embodiments, the optically active polycrystalline film of the photovoltaic device may be located between a radiation source and said electrode arrangement. The optically active semiconductor layer comprises a polycrystalline film that is chemically stable in oxygen and humidity conditions. Generally, the optically active semiconductor layer may comprise a polycrystalline film comprising crystallites of molecular salt that are at least partly insoluble in water. In some configuration, the optically active semiconductor consists of molecular salt that is at least partially insoluble in water. Preferably, for additional protection, the photovoltaic device may be further coated by clear-coat or semi clear-coat layer. The clear or semi clear-coat layer may be transparent for at least a predetermined wavelength range. Such transparent coating may be configured for protecting the optically active material from general environment conditions such as rain, hail, acid rain, snow, dirt, and physical damages.

Material composition of the first and second electrode elements of the photovoltaic device may be selected in accordance with the energy band structure of said optically active polycrystalline film to provide said selective collection of charge carriers.

According to some embodiments, the substrate is foldable or rollable to thereby enable efficient transport and deployment of the device at a desired site. This may provide a rollable or foldable photovoltaic device configuration. In some other embodiments, the photovoltaic device is configured of a plurality of tile substrates configured to fit together for covering a large surface at a desired site. Thereby simplifying shipping and assembly of the device.

In some configurations of the photovoltaic device, the optically active polycrystalline film may comprise material composition as defined above. Additionally or alternatively, the electrode arrangement and the first and second electrode elements thereof may be configured as described herein.

### BRIEF DESCRIPTION OF THE DRAWINGS

In order to better understand the subject matter that is disclosed herein and to exemplify how it may be carried out in practice, embodiments will now be described, by way of non-limiting example only, with reference to the accompanying drawings, in which:
Fig. 1 schematically illustrates an electrode arrangement configured for use in charge collection from a photovoltaic device according to some embodiments of the present invention;
**Figs. 2A to 2C** exemplify three configurations of an electrode element for use in an electrode arrangement as shown in Fig. 1;
**Figs. 3A and 3B** illustrate two examples of a single layer electrode arrangement configured for use in charge collection from a photovoltaic device according to some embodiments of the present invention; **Fig. 3A** exemplifies simple interdigital configurations and Fig. 3B exemplifies a fractal-like configuration;
**Fig. 4** schematically shows the energy band structure of the optically active medium and electrode arrangement according to some embodiments of the present invention;
**Fig. 5** shows an X-ray diffraction measurement of an optically active polycrystalline film provided according to the present invention;
**Fig. 6** shows transmission measurement of an optically active polycrystalline film provided according to the present invention;
**Fig. 7A** **and** **7B** show SEM images of an optically active polycrystalline film provided according to the present invention deposited from DMF;
**Fig. 8** shows a voltage-current response of an optically active polycrystalline film provided according to the present invention deposited from DMF;
**Figs. 9A to 9C** show a SEM image (**Fig. 9A**) and voltage-current response measurements (**Fig. 9B** **and** **9C**) of an optically active polycrystalline film provided according to the present invention deposited from Methanol;
**Figs. 10A to 10C** show a SEM image (Fig. 10A), an EDS spectrum (Fig. 10B) and a voltage-current response measurement (Fig. 10C) of a polycrystalline film deposited from methanol and water liquid carrier;
**Fig. 11** illustrates a method for providing a photovoltaic device according to the technique of the present invention; and
**Figs. 12A** and **12B** illustrate a configuration of a photovoltaic device according to some embodiments of the invention.

### DETAILED DESCRIPTION OF EMBODIMENTS

As described above, the present invention provides a novel concept for producing photovoltaic devices. The photovoltaic device according to the technique of the present invention may be produced or assembled on generally any surface, on the spot or in a dedicated location. The surface may generally be any desired surface such as a wall, floor, road, sidewalk, rooftop, movable platform, car outer surface, or any desired surface.

Typically, according to the present technique, an electrode arrangement is deployed on a selected surface to be converted to a photovoltaic device. The electrode arrangement may be glued, nailed or attached to the surface in any desired technique. An optically active mixture is applied on the surface and allowed to dry and/or cure, such that a liquid carrier of the mixture evaporates or a powder-like mixture is attached to the surface, and to leave a residue in the form of an optically active film on the surface. The material composition of the mixture and the material composition and configuration of the electrode arrangement are selected to provide effective harvesting of energy from electromagnetic radiation impinging on the treated surface.

Thus, in the photovoltaic device according to the claimed invention, a paint is provided that upon drying and/or curing produces a polycrystalline optically active film. The material includes colloidal structures, preferably suspended in a liquid carrier, in which additional one or more soluble material is/are dissolved. The colloidal particles and the one or more soluble material are selected such that when the liquid carrier evaporates, an optically active polycrystalline residue is formed. The optically active polycrystalline residue/film generates charge carriers in response to electromagnetic radiation (e.g. optical radiation) of one or more predetermined wavelength ranges incident thereon.

Additionally, in the photovoltaic device according to the claimed invention, an electrode arrangement is provided which is suitable to be used in charge collection from such a "painted" surface (in the meaning that a layer of coating material is applied on the surface). The electrode arrangement is configured to be applied on the surface before or after application of the paint material, such that the electrodes of the electrode arrangement collect charge carriers generated by the plurality of crystalline structures and conduct corresponding charges to a peripheral circuitry to be stored (e.g. in a battery), to the grid or to a load.

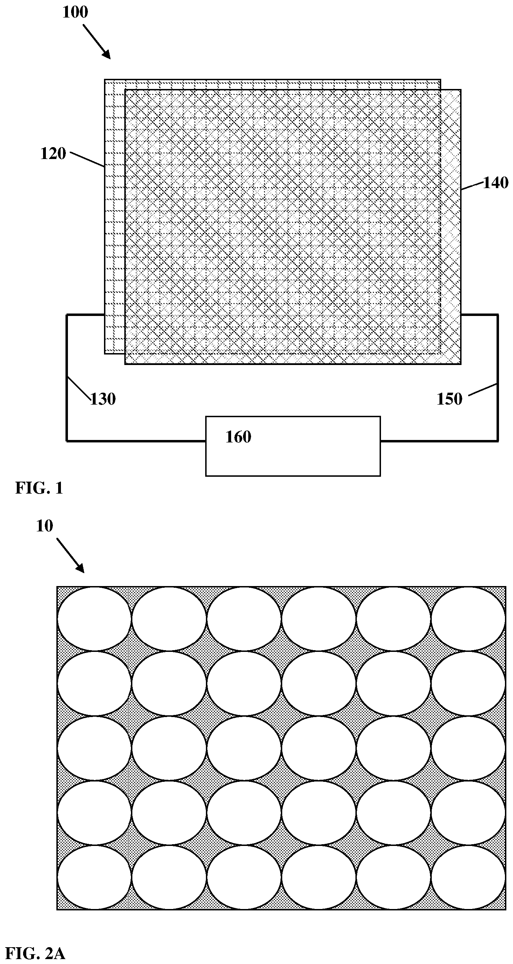

Reference is made to Fig. 1 schematically illustrating an electrode arrangement 100 configured for charge collection from a photovoltaic transformed surface. The electrode arrangement 100 includes a first 120 and second 140 electrode elements configured as generally planar patterned electrode elements. The first and second electrode elements **120** and **140** are configured to cover a predetermined surface in order to allow collection of charge carriers generated in the surface. Generally, the electrode arrangement 100 is a foldable, rolled arrangement or configured to be assembled from predetermined pieces and may be opened, extended or assembled to cover a desired surface. The electrode arrangement 100 may be attached, glued or nailed or otherwise reside in close proximity on the surface to interact with an optically active polycrystalline film applied to the surface before or after attaching the electrode arrangement. Generally it should be noted that the optically active polycrystalline film may be applied/attached to the electrode arrangement prior to attaching the electrode arrangement to the surface as the case may be.

The first and second electrode elements **120** and **140** may be configured as mesh electrodes, plate electrodes with plurality of holes in them, woven wires structure, finger members, etc. Generally, the electrode arrangement may be in any configuration providing close proximity between portions of the first and second electrode elements while having no direct electrical contact between them. The electrode elements are preferably configured with a fill factor of below 50%, i.e. the relative area of the electrode element (first 120 or second 140) covered by conducting material is no more than 50% and the remaining area is empty, being holes in a plate, spaces between lines, etc. In some configurations, the electrode elements may be configured with a fill factor of below 40%, or below 30%, or below 20% or below 10% with respect to hollowed regions of the electrode elements. Although it should be noted that higher values of fill factor may be used and in some configurations the electrode elements may be configured with a fill factor of up to 100%.

It should also be noted that in some embodiments of the invention, the electrode arrangement is prefabricated on an electrically isolating substrate such as but not limited to polyester, FR4, nylon, etc. In other embodiments, the substrate may have voids in it which allow the paint to penetrate the substrate and stick to the surface thereby securing the attachment of the electrodes to the surface by the paint material itself.

Typically, the electrode arrangement may be configured to allow the paint as well as light to reach the proximity of each of the electrode elements. This is to provide high coupling between the electrode elements of the electrode arrangement and optically active medium applied on or between the electrode elements to allow collection of charge carriers and thus efficient conversion of the surface to a photovoltaic energy harvesting surface.

To this end, once a surface has been selected for conversion, certain initial process may be applied for preparing the surface. Such initial process may include polishing existing paint, removing undesired materials, applying an electrically isolating layer etc. When the surface is ready for conversion, the electrode arrangement is placed on the surface such that the entire desired area is covered by the electrode arrangement. Then the paint mixture (e.g. liquid suspension) is applied on the covered surface, and allowed to dry and/or cure, leaving and optically active film. The optically active film that remains on the surface after evaporation of the liquid carrier and/or curing may form a film on top of the electrode arrangement 100 or penetrate between the first and second electrode elements **120** and **140,** such that polycrystalline structures of the optically active film are in electrical contact with regions of both the first and second electrode elements. It should be noted that some crystalline structures may be formed between portions of the electrode elements, i.e. in spaces between the elements. To this end, the electrode arrangement is preferably configured such that spaces between portions of the electrode elements are sufficiently small to allow efficient collection of charge carriers, e.g. in accordance with the diffusion radius of charged carriers in the optically active film.

The electrode elements provide charge collection in the meaning that at least one of the first and second electrode elements **120** and **140** is configured to allow selective collection of charge carriers, and preferably both of the electrode elements. For example, one of the electrode elements, e.g. the first electrode element 120, is configured to allow collection of negative charge carriers (typically electrons) and the other one, e.g. the second electrode element 140, is configured to allow collection of positive charge carriers (typically holes).

In this connection, the electrode arrangement may be configured as two- or more layers such that the first and second electrode elements are in different layers; or as a single layer electrode arrangement such that the first and second electrode elements are located in spaced apart relation within the same layer. In embodiments where the first and second electrode elements are in different layers of the electrode arrangement, the electrode elements are configured to allow optical radiation to pass through the hollowed regions of at least the top electrode element and to interact with crystalline structures causing them to generate charge carriers.

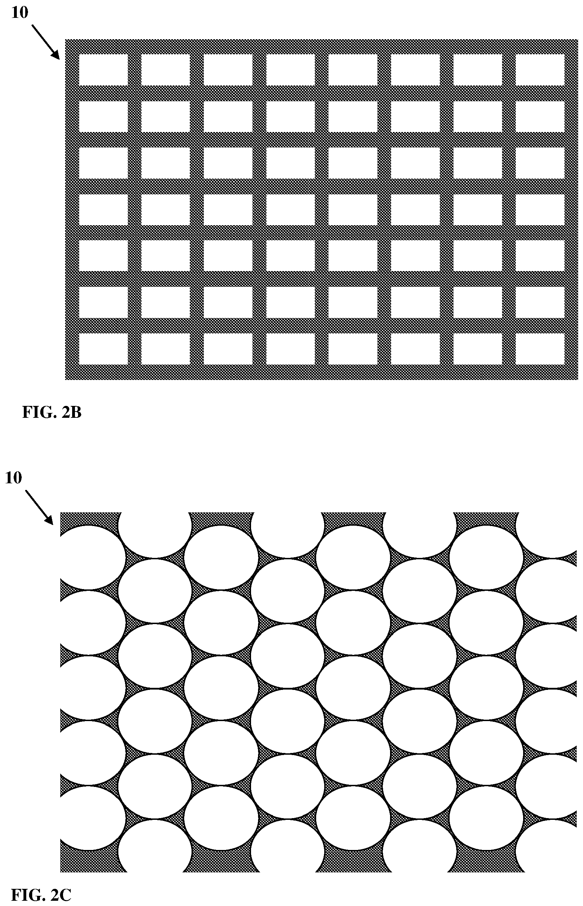

**Figs. 2A to 2C** illustrate some exemplary configurations of an electrode element 10 suitable for use as first 120 or second 140 electrode element of the electrode arrangement in accordance with embodiments utilizing bi-layer electrode arrangement 100. As indicated above, the electrode element 10 is configured such that a substantial surface area thereof is voids surrounded by electrically conducting material. **Fig. 2A** shows an electrode element configured as a plate having plurality of circular holes along its surface; Fig. 2B shows an electrode element configured as a net structure being a plate with holes or woven wires; and Fig. 2C shows another configuration of an electrode element with circular holes having a hexagonal arrangement.

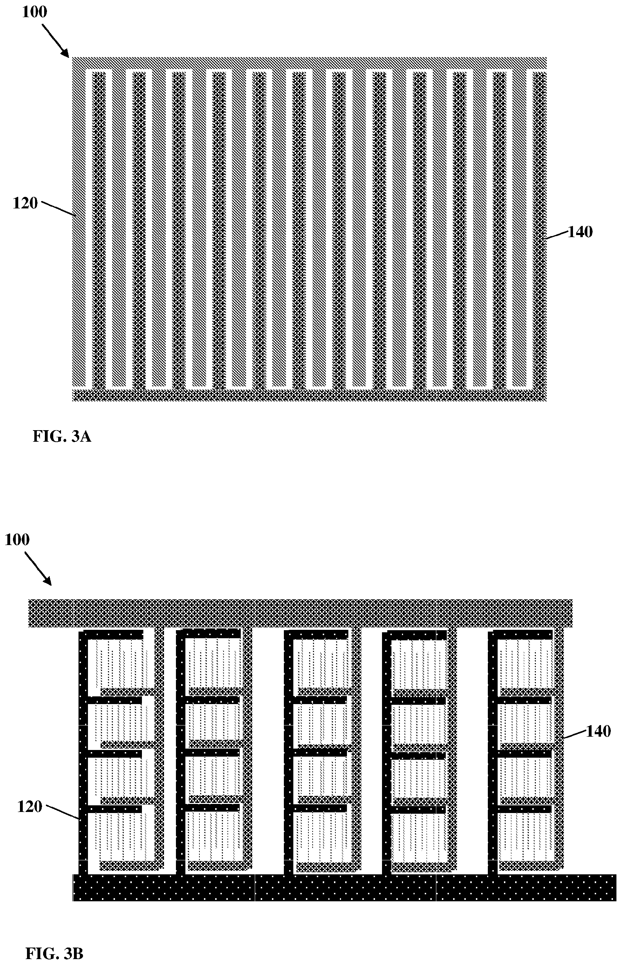

**Figs. 3A and 3B** show two examples of electrode arrangement 100 configured as a single layer arrangement. **Fig. 3A** shows an interdigital configuration of electrode elements **120** and **140** having a plurality of digit-like members and Fig. 3B shows a fractal-like interdigital configuration of electrode elements **120** and **140** having digit-like members in a plurality of interdigital region, the digit-like members are configured with smaller cross section further from external circuitry. As shown in these figures, the electrode arrangement may be configured as first 120 and second 140 electrode elements spaced apart within a single layer. In this example the first and second electrode elements **(120** and **140)** are configured as patterned flat electrode elements having a plurality of finger-like members thereby providing an interdigital arrangement of the finger members thereof. It should be noted that the fractal-like configuration of Fig. 3B may provide improved conductivity of collected charges as the cross section of the electrode portions grows to support transport of higher currents collected from larger regions of the photovoltaic device.

Generally, each electrode elements, being part of a single layer, bi-layer or any other configuration of the electrode arrangement, is configured as patterned thin (surface type) electrode elements, having thickness of about 500 nm to 500 µm. Typically the electrode arrangement 100 is provided in parts and is to be assembled, or is foldable or rolled, in order to save storage and simplify shipment thereof. Additionally, the electrode arrangement is preferably configured such that typical distance (shorter distance) between adjacent electrode portions of the first and second electrode elements corresponds to diffusion length of charge carriers, or to exciton radius, in an optically active film with which the electrode arrangement is configured to operate. For example, a typical distance between adjacent electrode potions may be between 100 nm and 500 µm, or between 1 µm and 100 µm. This distance corresponds to distance within the plane for a single layer arrangement or shorter distance between adjacent electrode portions between planes in a bi-layer arrangement. Also, the typical width of electrode portions, e.g. width of finger members, or continuous electrode portion, may generally be between 100 nm and 500 µm, or between 1 µm and 100 µm. This is to increase collection of charge carriers while reducing the probability of recombination prior to collection of the charge carriers by the electrode arrangement 100.

It should also be noted that the electrode arrangement may be applied on a flexible substrate such as, but not limited to, a polymer sheet for simple storage and deployment. Such a flexible polymer sheet may be degradable such that after application on a surface the polymer itself decomposes leaving the electrodes of the electrode arrangement on the surface. However, in some embodiments the polymer sheet may remain on the surface providing additional insulation of the photovoltaic device from the surface itself.

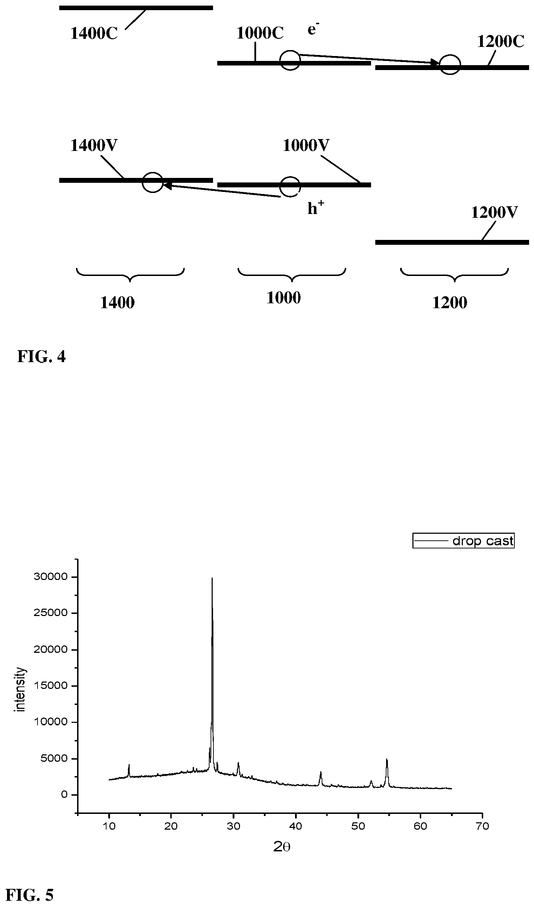

Generally, as indicated above, the first 120 and second 140 electrode elements of the electrode arrangement **100** are configured to allow selective collection of charge carriers. More specifically, the electrode elements of the electrode arrangement are configured such that the first electrode element 120 is configured to collect negative charge carriers (typically electrons) and second electrode element 140 is configured to collect positive charge carriers (typically holes). To this end, the first 120 and second 140 electrode elements are configured with a collection interface (e.g. coated by) of selected materials (e.g. semiconductor materials) having an effective valence and conduction bands (or work function in the case of metals for example) corresponding respectively to the effective valence and conduction bands of the optically active polycrystalline film used for generating the charge carriers. This is exemplified in Fig. 4 showing schematic energy band structures of the optically active polycrystalline film **1000,** and the first **1200** and second **1400** electrode elements respectively. As shown, the optically active material configured for absorbing electromagnetic radiation and generating in response charge carriers, is a semiconductor material having a band structure **1000** with an energy gap of about 0.5-3 eV, preferably 1-1.5 eV. Thus, in response to absorbed photons of sufficient energy, one or more electrons are excited from energetic states in the valence band **1000V** to energetic states in the conduction band **1000C,** leaving a positively charged hole in the valence band. The electrode elements of the electrode arrangement are configured with proper material composition having a suitable band structure such that available energy states for electrons, such as the work function or lower states of the conduction band of one of the electrode elements, e.g. conduction band **1200C** of electrode element 120, is energetically located at close proximity to conduction band of the optically active material **1000C,** and preferably with an energy that is slightly lower (with respect to the vacuum energy). This energy band arrangement allows negative charge carriers (typically electrons) to shift from the conduction band **1000C** of the optically active material to that of the electrode element **1200C,** and further to be conducted through conductive material of the electrode element 120 and suitable wires **130** (in **Fig. 1**) to the peripheral circuitry and from there to a storage unit, the grid or generally to a load **160** (in **Fig. 1****).** Similarly, the effective Fermi level (or valence band in semiconductors) **1400V** of the second electrode elements **1400** is energetically close to that of the valence band of the optically active material 1000V. This allows transition of holes from the optically active material to the electrode element, through suitable wires to the peripheral circuitry and from there to the storage/grid/load.

It should be noted the energy level of the effective valence band **1400V** or work function of the second (positive) electrode element 140 is of substantially similar and preferably a bit higher energy level as the effective valence level 1000V of the optically active material to allow collection of positive charge carriers (e.g. holes). This is while the conduction band **1400C** (in the case where the electrode coating is not metallic) of the same electrode element is located substantially higher with respect to the conduction band **1000C** of the optically active material, thus preventing collection of negative charge carriers (e.g. electrons). A similar but opposite relation is provided between the first (negative) electrode element 120 and the optically active material, i.e. the effective conduction band of the electrode 1200C is similar and preferably a bit lower energy level than the effective conduction band 1000C of the optically active material and the effective valence 1200V band energy level is substantially lower than the effective valence band 1000V of the optically active material, providing collection of negative charge carriers (e.g. electrons) while preventing collection of positive charge carriers (e.g. holes).

Generally, it should be understood, that to provide selective collection, at least one of the electrode elements, and preferably both electrode elements, is/are coated with suitable materials, selected in accordance with energetic and band properties of the optically active polycrystalline film. For example, as will be described in more details further below, the optically active polycrystalline film includes a semiconductor material, e.g. molecular salt, e.g. selected from Rb₂SnI₆, Cs₂SnI₆, Cs₂Sn₂I₆, Cs₂Sn₂Cl₆, Rb₂Sn₂Cl₆ CsSn₂I₅, Cs₂Sn₂Br₆ and Rb₂Sn₂Br₆. The corresponding electrode elements 120 and **140** of the electrode arrangement may thus be coated with or configured from materials (semiconductor or metals) having an energetic structure of the Fermi level or valence and conduction bands as described with reference to Fig. 4. For example, the first electrode element 120, configured for collection of negative charge carriers (e.g. electrons) may be configured from or coated with one or more of the following material compositions: n-Si, n-Ge, SnO₂, TiO₂, ZnO, and WO₃ to provide collection of negative charge carriers and to prevent collection of positive charge carriers. Additionally, the second electrode elements 140, configured for collection of positive charge carriers (e.g. holes) may be configured from or coated with one or more of the following material compositions: NiO, Au, GO (Graphene oxide), carbon nanotubes, graphene, graphite, fullerenes, CdS, ZnGaNO, Ni, Pt, NiO, MoO₂, CuO, Cu₂O, Cu₃O₄, CuS, Cu₃P, copper phenanthroline,Cu₂S, CuI, Fe₂S, iron oxides, iron sulfides, WO₂, CuSCN, Cu₃N and C₃N₄ to provide collection of positive charge carriers and to prevent collection of negative charge carriers. Various additional materials may be used and are selected in accordance with the electronic band structure of the optically active polycrystalline film as described in connection to Fig. 4.

In this connection, the optically active material generating charge carriers in response to impinging electromagnetic (e.g. optical) radiation is generally applied on the surface with a painting-like technique carried by a liquid carrier, or in a powder form. To this end, the present invention provides a medium for use in preparation of photovoltaic devices. The medium is typically in the form of a suitable mixture being in suspension and/or solution within a liquid carrier, or in some examples not forming part of the claimed invention, a powder mixture configured for direct application on the surface or further mixing with a suitable liquid carrier. The mixture includes at least one type (preferably at least two types) of a soluble composition and a plurality of nucleation assisting particles. The soluble composition(s) and nucleation assisting particles are selected to form together (in suitable conditions) a polycrystalline film of an optically active semiconductor, having crystallite grains around the nucleation assisting particles. Typically, when such a mixture is introduced in a liquid carrier, the soluble material(s) may form colloidal particles of nanometric or micrometric scale around the nucleation assisting particles forming a suspension in the liquid carrier.

In this connection, the paint-like mixture is described below in accordance with the embodiment of a colloidal suspension in a liquid carrier as defined in the claims. It should however be noted that substantially similar mixtures of material composition(s) may be provided in the form of a solution or a powder mixture to be applied on a desired surface. The material mixture is configured to be subsequent to drying and/or curing by evaporation of the liquid carrier e.g. by local or global heating or by suitable radiation to for an optically active polycrystalline film of the surface.

Thus, the suspension is based on colloidal structures of optically active semiconducting structures around nucleation assisting particles. Additionally, the suspension typically includes at least one soluble material, being soluble compounds associated with the optically active semiconducting structures of the colloidal particles. The at least one soluble material and the composition of the colloidal structures are selected such that when the liquid carrier is allowed to evaporate, the materials interact to form a continuous polycrystalline film of said optically active semiconducting structures.

Generally, the continuous polycrystalline film formed on the selected surface as a residue of the applied paint mixture is an optically active polycrystalline material The residue film, after evaporation of the liquid carrier, is typically of thickness of between 500 nm and a few micrometers and includes crystallite grains of dimensions between 50 nm and 500 µm, or between 100 nm and 10 µm.

Typically, the optically active medium is suspended (and partially dissolved) in a liquid carrier, which may be water (H₂O), alcohol (e.g. methanol, ethanol or propanol), dimethylformamide (DMF), dimethyl-sulfoxide (DMSO) and *N*-methyl-2-pyrrolidone (NMP) or a mixture thereof. For example, the liquid carrier may be a mixture of water and ethanol or methanol at a ratio of 1:9, 2:8, 4:6 or 4.57:5.53.

To this end, the optically active medium material is typically prepared in a solution utilizing colloidal nucleation assisting particles. The interaction of the soluble components of the optically active semiconductor material with the nucleation assisting particles forms colloidal structures of the optically active semiconductor around nucleation assisting particles suspended in the liquid carrier. The nucleation assisting particles may be of diameter between 1 nm and up to 1 mm and preferably between 10 nm and 50 µm, and having a material composition selected to maintain form in the liquid carrier and provide physical or chemical interaction with soluble material in the carrier to form nano-structures or micro-structures of the optically active semiconductor around the nucleation assisting particles. Generally, the nucleation assisting particles may be selected as oxides, nitrides, halides, sulfides or phosphides of suitable compositions. Alternatively, the nucleation assisting particles may be plasmonic nanoparticles, nano-cellulose particles or fiberglass particles. For example, the nucleation assisting particles may be selected from fumed silica (SiO₂), SnO₂, Al₂O₃, TiO₂, nano-cellulose, gold particles, aluminum particles, silver particles, copper particles and carbon particles, or any combinations thereof.

The optically active medium may also include additional materials, being either suspended particles or soluble material compositions. Such additional materials may generally include binding materials configured to assist in binding of the optically active polycrystalline film to the surface (or to the electrode arrangement) upon evaporation of the liquid carrier and/or curing of the optically active material; dopants configured to vary the density of charge carriers and/or to increase conduction properties of the optically active polycrystalline film; mechanical and chemical crystalline film structure enhancement; and in some configurations, one or more pigment materials. For example, such binding materials may be selected from polyalkylacrylates, poly(meth)acrylates, polyalkyl(meth)acrylate and polysiloxanes, each configured to assist in binding of the polycrystalline residue to the surface, or to electrodes of the electrode arrangement, after evaporation of the liquid carrier and/or curing thereof.

It should be noted that pigment materials may be added to the suspension to provide variety of colors to the optically active polycrystalline film. However, it should be clear that the final color of the film will typically be dark, being a high absorber of light. Suitable pigments may include metallic nanoparticles such as gold, silver, aluminum or other metals; dye materials; or semiconductor nanoparticles. Such pigments may provide a certain level of reflection for light of one or more wavelength range giving the final photovoltaic device a hint of color.

It should be noted that according to some embodiments of the invention, a color finish may be provided to the photovoltaic device in the form of a semi-clear coating applied on the optically active material. Such a semi-clear coating may be configured to reflect a portion of light in desired one or more wavelength ranges to thereby provide the desired color to the surface while allowing the remaining portions of impinging light to excite the optically active material.

According to an example of the invention, appropriate amounts of SnI₄ and CsI (1:2 in this example) were measured and mixed in the correct stoichiometry. The mixture was dissolved in several liquid carriers, including methanol, and DMF together with SnO₂, alumina and silica particles. Several such mixtures were prepared in different containers. Generally, the interaction between the soluble ionic materials and the nanoparticles (acting as nucleation assisting particles) created a suspension of colloidal structures as described above.

The mixture/suspension was applied on a designated test surface carrying an electrode arrangement as shown in **Fig. 3** above, utilizing SnO₂ and CuO coatings. In this case the suspension was drop-cast on the surface; however, other methods may be used, such as spray, airless, airbrush, applied by putty knife (e.g. Dr. Blade), brush, roller, electrostatic etc. After application of the optically active medium (in the form of suspension or solution) on the surface it was left to dry. To speed up evaporation of the liquid carrier, substrate was locally heated to 90°C utilizing a heat gun. It should however be noted that giving sufficient drying time (e.g. up to 12-24 hours) the liquid carrier may evaporate in room temperature, and generally no specific heating is required. Fig. 5 shows X-ray diffraction measurements of the semiconductor film left on the surface after evaporation of the liquid carrier exemplifying the crystal structure of the semiconductor.

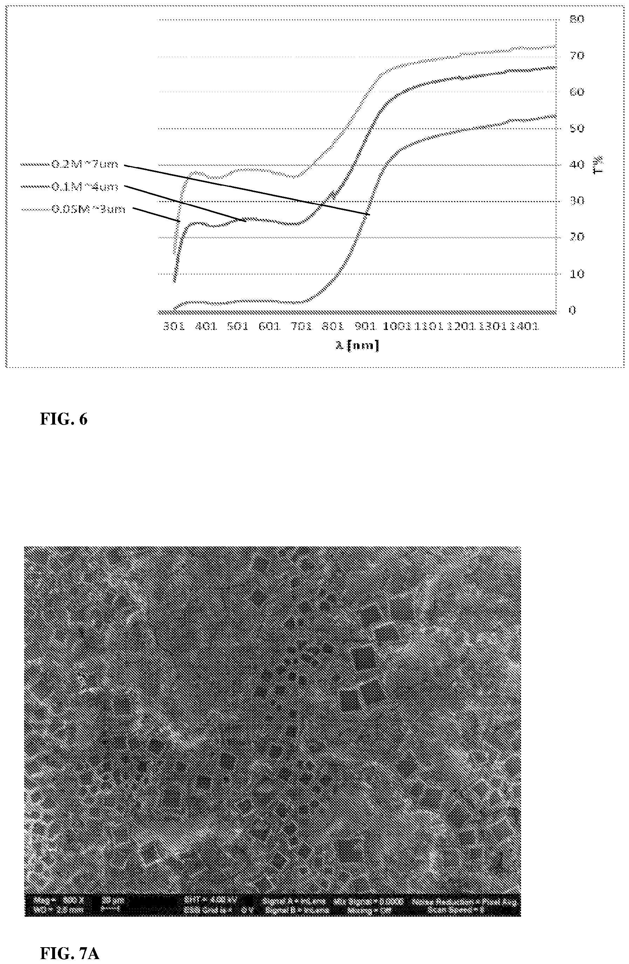

Optical activity (absorption) of the polycrystalline film was measured for different film thicknesses as shown in Fig. 6 showing transmission of light through the optically active polycrystalline film. The residue film absorbs light from about 300nm to 800nm (visible spectrum) showing an energy gap of about 1.3eV, being suitable for use on photovoltaic device utilizing solar radiation.

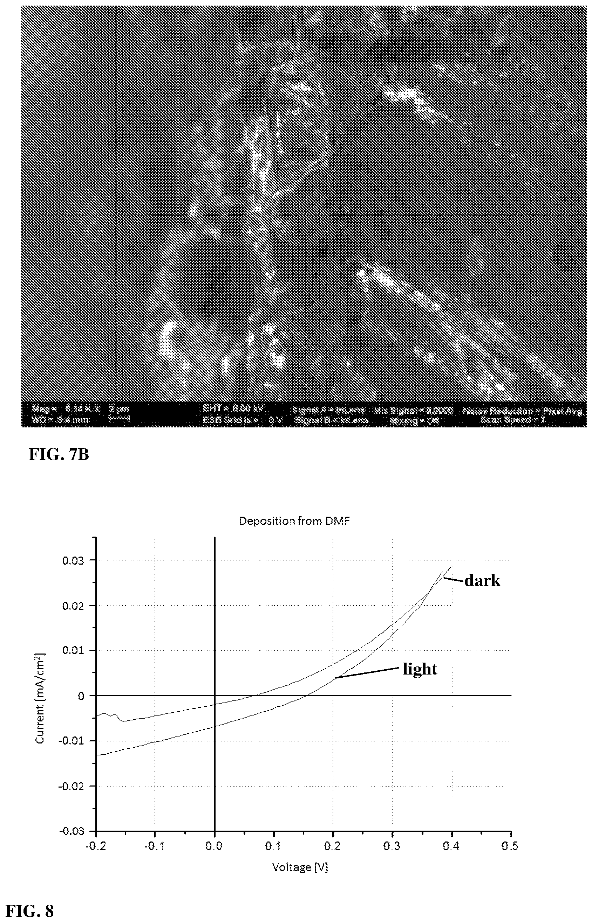

Additionally, **Figs. 7A** **and** **7B** show top and side scanning electron microscope (SEM) images of the polycrystalline film respectively. In this example, the optically active semiconductor material was deposited from DMF suspension. The SEM scans were performed after casting the medium on a surface and evaporation of the DMF liquid carrier by heating. These scans show a polycrystalline configuration of molecular salt crystallites including larger crystallites regions surrounded by amorphous material. Generally the crystallites regions are formed of the material composition of Cs₂SnₓI₆ crystallite structures, suitable for use as an optically active semiconductor, according to the technique of the invention. Fig. 8 shows I-V measurements (current in response to external voltage) of the polycrystalline film under dark and light conditions (100 mW/cm² corresponding to 1 sun illumination conditions). This measurement indicates that this polycrystalline film may provide an operating voltage of at least 300 mV and current density of at least 0.2 mA/cm² under suitable illumination, however it should be noted that upon optimization, current of up to 35 mA/cmand voltage of up to 1 V may be obtained with this material composition.

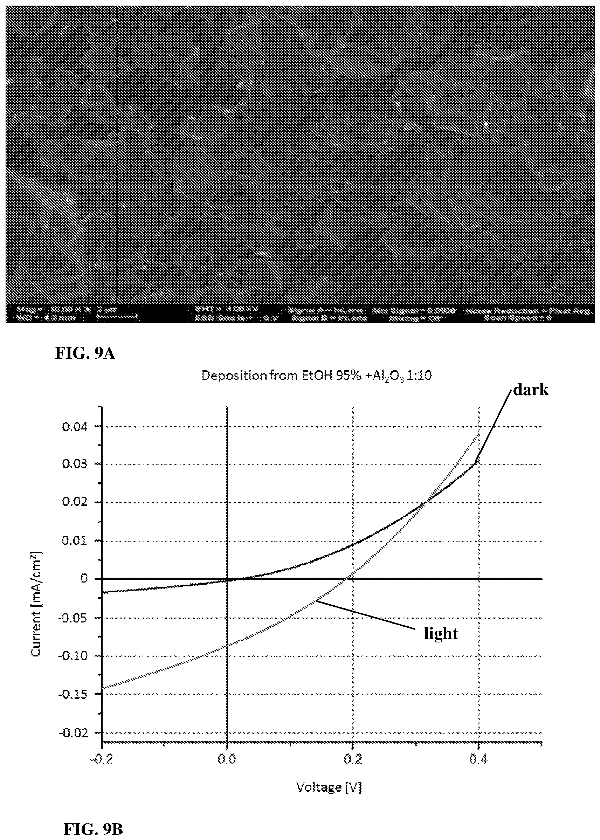

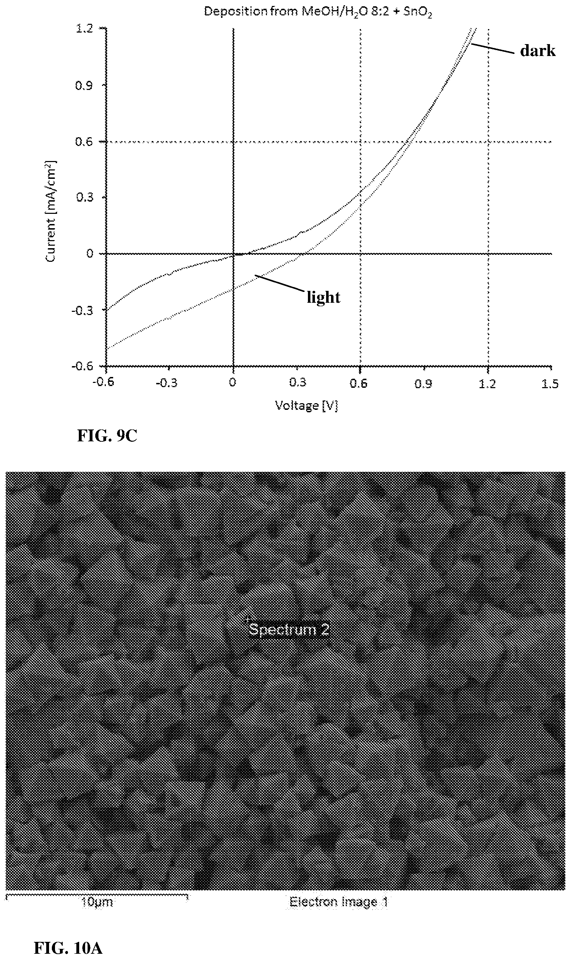

An additional example of the polycrystalline molecular salt deposited from alcohol-based suspensions of the mixture described above is shown in **Figs. 9A to** 9C. Fig, 9A shows a SEM image of the resulting polycrystalline film; and Fig. 9B shows I-V measurement for polycrystalline film deposited from 95% ethanol suspension utilizing Al₂O₃ based nucleation assisting particles; **and 9C** shows I-V measurements for polycrystalline film deposited from methanol and water suspension with mixing ratio of 8:2 with SnO₂ nucleation assisting particles. Both I-V measurements were conducted in dark conditions and under illumination of 100 mW/cm². As can be seen from **Fig. 9A****,** the polycrystalline film includes crystallites with octahedral geometry indicating the desired optically active semiconductor film corresponding to the expected structure of Cs₂SnI₆ crystallites. The resulting measurements of **Fig. 9B** **and** **9C** indicate operation voltages of between 55 to 280 mV and current densities of 0.1-0.2mA/cm².

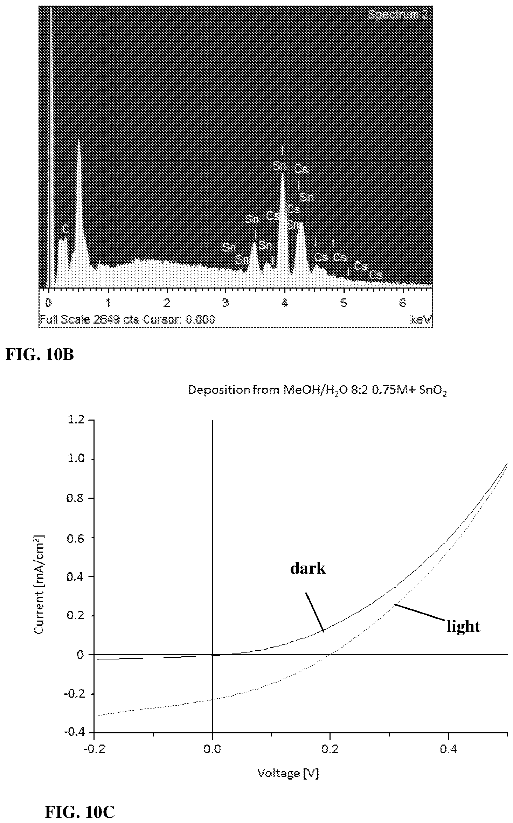

In another example, CsI and SnI₄ were dissolved at ratio of 2:1 in a mixture of 4 parts methanol and one part water together with SnO₂ particles. The liquid was applied on a surface and cured in temperature of 90°C to allow the liquids to evaporate and generate polycrystalline film. **Fig. 10A** shows a SEM scan of the remaining polycrystalline film; **Fig. 10B** shows an energy-dispersive X-ray spectroscopy (EDS) measurement of **spectrum** 2 point marked in Fig. **10A****;** and **Fig.** 10C shows I-V measurements in dark conditions and under illumination of 100 mW/cmof the film. As can be seen from **Fig. 10B****,** the polycrystalline film is mostly Cs₂SnI₆ in composition. Fig. 10C shows specific photovoltaic activity by the polycrystalline film.

Other materials having suitable energetic properties (such as band gap and optical absorption) and are capable of forming polycrystalline films below 500°C are also suitable for use for providing a photovoltaic device according to the present technique. Several such material compositions include, but are not limited to, the following: CsSn₂I₅, CsSnI₃, Rb₂SnI₆, CsPbI₃, Cs₂PbI₆, (CH₃NH₃)PbI₃, HC(NH₂)₂PbI₃, (CH₃NH₃)SnI₃ and HC(NH₂)₂SnI₃.

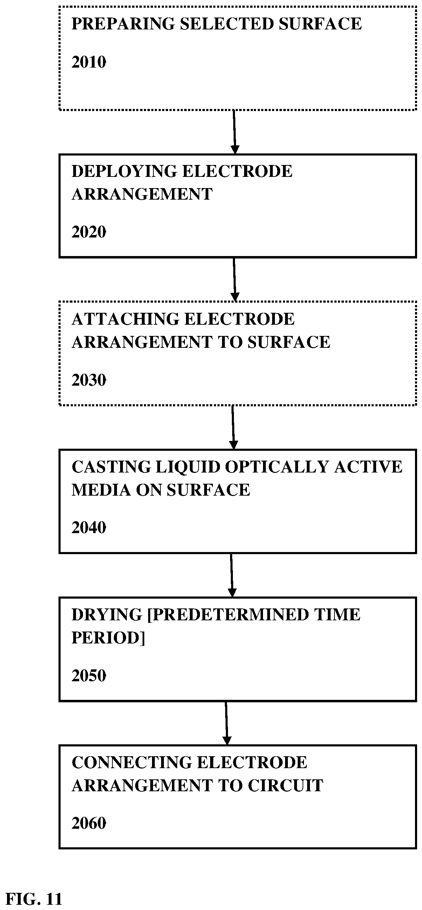

Reference is made to Fig. 11 illustrating in a way of a block diagram a method for preparing a photovoltaic device based on a surface. As indicated above, the surface may generally be any desired surface such as wall, road, sidewalk, portable plate, car roof etc. Generally, the surface may need to be prepared **2010.** For example, the surface may require cleaning, removing old paint layers, removing obstacles, etc. However, the surface may be pre-prepared and ready to be used as a photovoltaic device. Then the electrode arrangement is placed on the surface **2020,** covering the regions that are to be used as parts of the photovoltaic device. The electrode arrangement may require to be attached to the surface **2030** using nails, glue, cement or any suitable technique. Once the electrode arrangement is in place, the surface is ready for application of the paint **2040.** As indicated above, the paint mixture may be in the form of solution or suspension in a liquid carrier or as powder mixture. The paint material may be applied to the surface in various desired techniques, including drop-casted, applied by putty knife, sprayed, brushed or any other suitable application technique. It is preferred that the paint material uniformly cover regions corresponding to the location of the electrode arrangement. The paint material may be allowed to dry and/or cure within 12-24 hours, or be cured or heated, e.g. by heating of the surface to temperatures of up to 200°C, in accordance with the desired time period for evaporation of the liquid carrier or utilizing radiation in one or more predetermined wavelength ranges (such as UV illumination) thus providing an optically active film **2050.** This can be done for example by utilizing a heat gun, electrical heating through the electrodes or any other suitable technique. Generally heating to 100°C may be sufficient, and slow drying at room temperature may be preferred for some embodiments. The electrodes of the electrode arrangement may than be connected to a grid, or any desired electrical circuit to provide conduction for harvested energy **2060.**

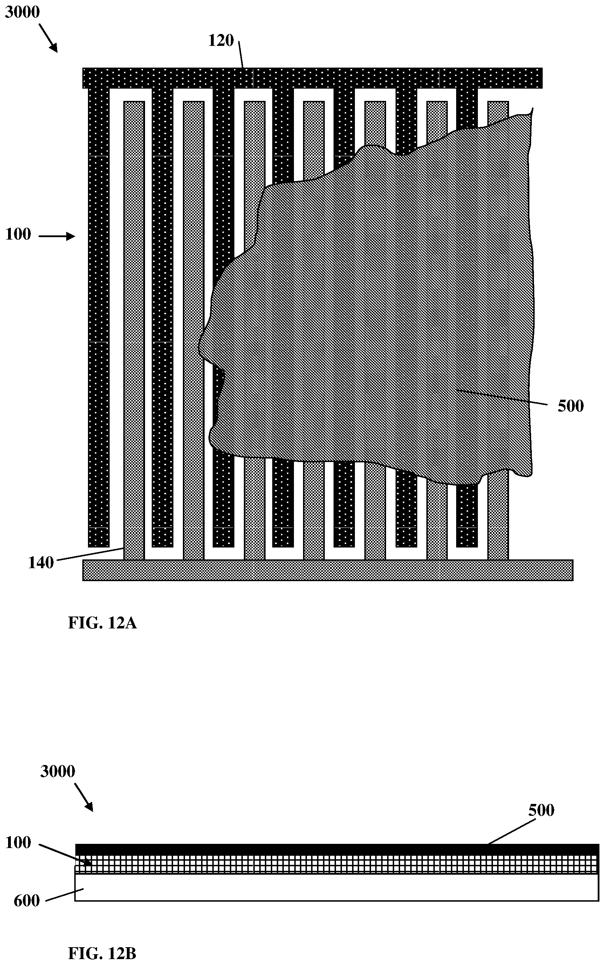

In this connection, reference is made to **Figs. 12A and 12B** illustrating a photovoltaic devices **3000** according to embodiments of the present invention. **Fig. 12A** illustrates a top view and **Fig. 12B** illustrates a side view of the device **3000.** As shown the device includes an electrode arrangement 100 as described above, i.e. including two electrode elements **120** and **140** configured for collecting charges from an optically active layer, placed on a surface 600; and a layer of optically active semiconductor 500 on external surface of the electrode arrangement. At least one of the electrode elements of the electrode elements, e.g. element 120, is configured of material composition selected in accordance with the optically active semiconductor 500, such that electrode element 120 allows collection of charges of a specific sign (i.e. only positive or only negative charges). In some embodiments, as described above, both electrode elements **120** and **140** of the electrode arrangement are configured for specific collection or either positive of negative charge carriers. It should be noted, as described above, that the electrode elements **120** and **140** may be coated by thin layer of metal or semiconductor as described above, selected in accordance with the energy band structure of the optically active semiconductor layer 500.

Preferably, the electrode arrangement 100 is configured such that electrode portions of the first 120 and second 140 electrode elements are spaced apart between them to prevent short circuit, while having distances of between 1 µm and 100 µm to allow collection of charges generated in the optically active layer 500 in response to impinging electromagnetic radiation. The electrode elements may be in a single layer or in different layer as described above with reference to **Figs. 1****,** **2A-2C and** 3. The optically active semiconductor layer **500** may penetrate within spaces or holes of the electrode elements to provide enhanced charge collection therefrom.

As also shown in **Fig. 10B****,** the optically active semiconductor **500** is preferably directly exposed to impinging radiation. This is provided by arranging both the first **120** and second **140** electrode elements (generally at least one of them) as charge selective collector elements. This configuration reduces costs associated with photovoltaic devices as it eliminates the need for the use of an optically transparent electrode.

As also described above, the optically active semiconductor **500** is configured as a polycrystalline film of optically active material. The semiconductor is preferably a molecular salt, and may be deposited from solution or suspension utilizing nucleation centers and drying or curing. In some preferred embodiments, the semiconductor layer is cured at a temperature below 500°C or even below 100°C.

Typically, the photovoltaic device **3000** may be assembled on-site on a selected surface, or pre-assembled. For example, the photovoltaic device **3000** may be provided on a surface/substrate **600** that is foldable or that is configured of a plurality of relatively small sections that may be arranged and assembled together to be deployed in a desired location.

Thus, the present invention provides a novel concept in forming photovoltaic devices. The technique, electrode arrangement and optically active medium of the invention may be used separately, or in combination, to provide a simple and robust photovoltaic device that may be assembled on the spot or in any desired location.

## Claims

1. A photovoltaic device comprising a layered structure on a substrate comprising:
an electrode arrangement (100) comprising first (120) and second (140) patterned electrode elements and an optically active semiconductor layer (500) in direct interaction with said electrode arrangement (100),
said optically active semiconductor layer (500) being configured to generate charge carriers in response to impinging electromagnetic radiation;
the electrode arrangement (100) being configured, in accordance with material properties of said optically active semiconductor layer (500), to allow selective collection of charge carriers of opposite polarities generated in said optically active semiconductor layer (500) by the first (120) and second (140) electrodes respectively;
wherein said optically active semiconductor layer (500) is located between a radiation source and said electrode arrangement 100;
**characterized in that**:
the optically active semiconductor layer (500) comprises optically active semiconducting structures that are selected from: Rb₂SnₘI₆, Cs₂SnₘI₆, Cs₂SnₘCl₆, Rb₂SnₘCl₆, CsSnₘI₃, Cs₂SnₘBr₆, Rb₂SnₘBr₆, and any combination of them; wherein each value of m, independently of the other, is between 0.2 and 6.

2. The photovoltaic device of Claim 1,
wherein said optically active semiconductor layer (500) is directly exposed to input electromagnetic radiation.

3. The photovoltaic device of Claim 1 or 2,
wherein said optically active semiconductor layer (500) comprises a polycrystalline film deposited from liquid carrier at temperature below 500°C.

4. The photovoltaic device of any one of Claims 1 to 3,
wherein said optically active semiconductor layer (500) comprises a polycrystalline film that is chemically stable in oxygen and humidity conditions.

5. The photovoltaic device of any one of Claims 3 to 4,
wherein material composition of said first (120) and second (140) electrode elements is selected in accordance with the energy band structure of said polycrystalline film to provide said selective collection of charge carriers.

6. The photovoltaic device of any one of Claims 1 to 5,
wherein said substrate is foldable or rollable to thereby enable efficient transport and deployment of the photovoltaic device at a desired site.

7. The photovoltaic device of any one of Claims 1 to 6
wherein said photovoltaic device is configured of a plurality of tile substrates configured to fit together for covering a large surface at a desired site.

8. The photovoltaic device of any one of Claims 1 to 7,
wherein said electrode arrangement (100) is configured as a single layer electrode arrangement and comprising first and second interdigital electrode elements.

9. The photovoltaic device of any one of Claims 1 to 7,
wherein said electrode arrangement (100) is configured as multi-layer electrode arrangement and comprising a mesh or grid like first and second electrode elements separated between them by regions of insulating material, and
wherein said optically active semiconductor layer (500) penetrates between region of said first (120) and second (140) electrode elements to thereby enable electrical contact with said first (120) and second (140) electrode elements.

10. A method of assembling a photovoltaic device on a surface, the method comprising:
providing on said surface an electrode arrangement (100) in direct interaction with a liquid medium, and allowing said medium to be dried or cured thereby creating an optically active film interacting with the electrode arrangement (100), wherein:
said liquid medium comprises a liquid carrier comprising: suspended colloidal structures comprising nucleation assisting particles and optically active semiconducting structures; and at least one soluble material selected to interact with said colloidal structures on said surface to create a continuous optically active polycrystalline film; and
the electrode arrangement (100) comprises at least first (120) and second (140) patterned electrodes configured, in accordance with material properties of said optically active semiconductor film, to allow selective collection of charge carriers of opposite polarities generated in said optically active semiconductor film by the first (120) and second (140) electrodes respectively;
**characterized in that**:
the optically active semiconductor film comprises optically active semiconducting structures that are selected from: Rb₂SnₘI₆, Cs₂SnₘI₆, Cs₂SnₘCl₆, Rb₂SnₘCl₆, CsSnₘI₃, Cs₂SnₘBr₆, Rb₂SnₘBr₆, and any combination of them; wherein each value of m, independently of the other, is between 0.2 and 6.

## Patentansprüche

1. Photovoltaikvorrichtung, umfassend eine Schichtstruktur auf einem Substrat, umfassend:
eine Elektrodenanordnung (100), umfassend erste (120) und zweite (140) strukturierte Elektrodenelemente und eine optisch aktive Halbleiterschicht (500) in direkter Wechselwirkung mit der Elektrodenanordnung (100),
wobei die optisch aktive Halbleiterschicht (500) konfiguriert ist, um als Reaktion auf auftreffende elektromagnetische Strahlung Ladungsträger zu erzeugen;
wobei die Elektrodenanordnung (100) in Übereinstimmung mit Materialeigenschaften der optisch aktiven Halbleiterschicht (500) konfiguriert ist, um eine selektive Sammlung von Ladungsträgern entgegengesetzter Polaritäten zu ermöglichen, die in der optisch aktiven Halbleiterschicht (500) durch die ersten (120) beziehungsweise zweiten (140) Elektroden erzeugt werden;
wobei sich die optisch aktive Halbleiterschicht (500) zwischen einer Strahlungsquelle und der Elektrodenanordnung 100 befindet;
**dadurch gekennzeichnet, dass**:
die optisch aktive Halbleiterschicht (500) optisch aktive halbleitende Strukturen umfasst, die ausgewählt sind aus: Rb₂SnₘI₆, Cs₂SnₘI₆, Cs₂SnₘCl₆, Rb₂SnₘCl₆, CsSnₘI₃, Cs₂SnₘBr₆, Rb₂SnₘBr₆ und einer beliebigen Kombination davon; wobei jeder Wert von m unabhängig von dem anderen zwischen 0,2 und 6 liegt.

2. Photovoltaikvorrichtung nach Anspruch 1,
wobei die optisch aktive Halbleiterschicht (500) elektromagnetischer Eingangsstrahlung direkt ausgesetzt ist.

3. Photovoltaikvorrichtung nach Anspruch 1 oder 2,
wobei die optisch aktive Halbleiterschicht (500) einen polykristallinen Film umfasst, der von einem flüssigen Träger bei einer Temperatur unter 500 °C abgeschieden wird.

4. Photovoltaikvorrichtung nach einem der Ansprüche 1 bis 3,
wobei die optisch aktive Halbleiterschicht (500) einen polykristallinen Film umfasst, der unter Sauerstoff- und Feuchtigkeitsbedingungen chemisch stabil ist.

5. Photovoltaikvorrichtung nach einem der Ansprüche 3 bis 4,
wobei die Materialzusammensetzung der ersten (120) und der zweiten (140) Elektrodenelemente in Übereinstimmung mit der Energiebandstruktur des polykristallinen Films ausgewählt wird, um die selektive Sammlung von Ladungsträgern bereitzustellen.

6. Photovoltaikvorrichtung nach einem der Ansprüche 1 bis 5,
wobei das Substrat faltbar oder rollbar ist, um dadurch einen effizienten Transport und Einsatz der Photovoltaikvorrichtung an einem gewünschten Ort zu ermöglichen.

7. Photovoltaikvorrichtung nach einem der Ansprüche 1 bis 6,
wobei die Photovoltaikvorrichtung aus mehreren Fliesensubstraten konfiguriert ist, die konfiguriert sind, um zusammenzupassen, um eine große Oberfläche an einem gewünschten Ort abzudecken.

8. Photovoltaikvorrichtung nach einem der Ansprüche 1 bis 7,
wobei die Elektrodenanordnung (100) als eine einschichtige Elektrodenanordnung konfiguriert ist und erste und zweite Interdigitalelektrodenelemente umfasst.

9. Photovoltaikvorrichtung nach einem der Ansprüche 1 bis 7,
wobei die Elektrodenanordnung (100) als mehrschichtige Elektrodenanordnung konfiguriert ist und maschen- oder gitterartige erste und zweite Elektrodenelemente umfasst, die zwischen ihnen durch Bereiche aus Isoliermaterial getrennt sind, und
wobei die optisch aktive Halbleiterschicht (500) zwischen den Bereich der ersten (120) und der zweiten (140) Elektrodenelemente eindringt, um dadurch einen elektrischen Kontakt mit den ersten (120) und den zweiten (140) Elektrodenelementen zu ermöglichen.

10. Verfahren zum Montieren einer Photovoltaikvorrichtung auf einer Oberfläche, wobei das Verfahren umfasst:
Bereitstellen einer Elektrodenanordnung (100) auf der Oberfläche in direkter Wechselwirkung mit einem flüssigen Medium und Ermöglichen, dass das Medium getrocknet oder ausgehärtet wird, wobei dadurch ein optisch aktiver Film gebildet wird, der mit der Elektrodenanordnung (100) wechselwirkt, wobei:
das flüssige Medium einen flüssigen Träger umfasst, umfassend: suspendierte kolloidale Strukturen, umfassend nukleationsunterstützende Partikel und optisch aktive halbleitende Strukturen; und wenigstens ein lösliches Material, das ausgewählt ist, um mit den kolloidalen Strukturen auf der Oberfläche wechselzuwirken, um einen kontinuierlichen optisch aktiven polykristallinen Film zu bilden; und
die Elektrodenanordnung (100) wenigstens erste (120) und zweite (140) strukturierte Elektroden umfasst, die in Übereinstimmung mit Materialeigenschaften des optisch aktiven Halbleiterfilms konfiguriert sind, um eine selektive Sammlung von Ladungsträgern entgegengesetzter Polaritäten zu ermöglichen, die in dem optisch aktiven Halbleiterfilm durch die ersten (120) beziehungsweise die zweiten (140) Elektroden erzeugt werden;
**dadurch gekennzeichnet, dass**:
der optisch aktive Halbleiterfilm optisch aktive halbleitende Strukturen umfasst, die ausgewählt sind aus: Rb₂SnₘI₆, Cs₂SnₘI₆, Cs₂SnₘCl₆, Rb₂SnₘCl₆, CsSnₘI₃, Cs₂SnₘBr₆, Rb₂SnₘBr₆ und einer beliebigen Kombination davon; wobei jeder Wert von m unabhängig von dem anderen zwischen 0,2 und 6 liegt.

## Revendications

1. Dispositif photovoltaïque comprenant une structure en couches sur un substrat comprenant :
un agencement d'électrodes (100) comprenant des premier (120) et second (140) éléments électrodes à motifs et une couche semi-conductrice optiquement active (500) en interaction directe avec ledit agencement d'électrodes (100),
ladite couche semi-conductrice optiquement active (500) étant conçue pour générer des porteurs de charge en réponse à un rayonnement électromagnétique incident ;
l'agencement d'électrodes (100) étant conçu, conformément aux propriétés matérielles de ladite couche semi-conductrice optiquement active (500), pour permettre la collecte sélective de porteurs de charge de polarités opposées générés dans ladite couche semi-conductrice optiquement active (500) par les premier (120) et seconde (140) électrodes respectivement ;
ladite couche semi-conductrice optiquement active (500) étant située entre une source de rayonnement et ledit agencement d'électrodes 100 ; **caractérisé en ce que** :
la couche semi-conductrice optiquement active (500) comprend des structures semi-conductrices optiquement actives qui sont choisies parmi : Rb₂SnₘI₆, Cs₂SnₘI₆, Cs₂SnₘCl₆, Rb₂SnₘCl₆, CsSnₘI₃, Cs₂SnₘBr₆, Rb₂SnₘBr₆, et toute combinaison de ceux-ci ; chaque valeur de m, indépendamment l'une de l'autre, étant comprise entre 0,2 et 6.

2. Dispositif photovoltaïque selon la revendication 1, ladite couche semi-conductrice optiquement active (500) étant directement exposée à un rayonnement électromagnétique d'entrée.

3. Dispositif photovoltaïque selon la revendication 1 ou 2, ladite couche semi-conductrice optiquement active (500) comprenant un film polycristallin déposé à partir d'un véhicule liquide à une température inférieure à 500°C.

4. Dispositif photovoltaïque selon l'une quelconque des revendications 1 à 3, ladite couche semi-conductrice optiquement active (500) comprenant un film polycristallin qui est chimiquement stable dans des conditions d'oxygène et d'humidité.

5. Dispositif photovoltaïque selon l'une quelconque des revendications 3 à 4, ladite composition matérielle desdits premier (120) et second (140) éléments électrodes étant choisie conformément à la structure de bande d'énergie dudit film polycristallin pour obtenir ladite collecte sélective de porteurs de charge.

6. Dispositif photovoltaïque selon l'une quelconque des revendications 1 à 5, ledit substrat étant pliable ou enroulable pour permettre ainsi un transport et un déploiement efficaces du dispositif photovoltaïque sur un site souhaité.

7. Dispositif photovoltaïque selon l'une quelconque des revendications 1 à 6, ledit dispositif photovoltaïque étant conçu à partir d'une pluralité de substrats de tuile conçus pour s'ajuster ensemble pour couvrir une grande surface sur un site souhaité.

8. Dispositif photovoltaïque selon l'une quelconque des revendications 1 à 7, ledit agencement d'électrodes (100) étant conçu sous la forme d'un agencement d'électrodes à couche unique et comprenant des premier et second éléments électrodes interdigités.

9. Dispositif photovoltaïque selon l'une quelconque des revendications 1 à 7, ledit agencement d'électrodes (100) étant conçu sous la forme d'un agencement d'électrodes multicouches et comprenant des premier et second éléments électrodes en forme de maille ou de grille séparés entre eux par des zones de matériau isolant, et
ladite couche semi-conductrice optiquement active (500) pénétrant entre la zone desdits premier (120) et second (140) éléments électrodes pour permettre ainsi un contact électrique avec lesdits premier (120) et second (140) éléments électrodes.

10. Procédé d'assemblage d'un dispositif photovoltaïque sur une surface, le procédé comprenant :
la fourniture sur ladite surface d'un agencement d'électrodes (100) en interaction directe avec un milieu liquide, et permettre audit milieu d'être séché ou durci, créant ainsi un film optiquement actif interagissant avec l'agencement d'électrodes (100),
ledit milieu liquide comprenant un véhicule liquide comprenant : des structures colloïdales en suspension comprenant des particules d'assistance à la nucléation et des structures semi-conductrices optiquement actives ; et au moins un matériau soluble choisi pour interagir avec lesdites structures colloïdales sur ladite surface pour créer un film polycristallin optiquement actif continu ; et
l'agencement d'électrodes (100) comprenant au moins des première (120) et seconde (140) électrodes à motif conçues, conformément aux propriétés matérielles dudit film semi-conducteur optiquement actif, pour permettre la collecte sélective de porteurs de charge de polarités opposées générés dans ledit film semi-conducteur optiquement actif par les première (120) et seconde (140) électrodes respectivement ; **caractérisé en ce que** :
le film semi-conducteur optiquement actif comprend des structures semi-conductrices optiquement actives qui sont choisies parmi : Rb₂SnₘI₆, Cs₂SnₘI₆, Cs₂SnₘCl₆, Rb₂SnₘCl₆, CsSnₘI₃, Cs₂SnₘBr₆, Rb₂SnₘBr₆, et toute combinaison de ceux-ci ; chaque valeur de m, indépendamment l'une de l'autre, étant comprise entre 0,2 et 6.
